# EUROPÄISCHE PATENTSCHRIFT

(11) **EP 2 280 592 B1**
(45) Veröffentlichungstag und Bekanntmachung des Hinweises auf die Patenterteilung: **02.05.2012**
(21) Anmeldenummer: 10162085.4
(22) Anmeldetag: 06.05.2010
(51) Int. Cl.: H05K 3/24

(54) **Ausbilden einer Kontaktfläche auf einer Leiterplatte**
Construction of a contact area on a circuit board
Développement d'une surface de contact sur une plaque conductrice

(30) Priorität: 06.07.2009 DE 102009027470
(43) Veröffentlichungstag der Anmeldung: 02.02.2011
(73) Patentinhaber: Robert Bosch GmbH, 70442 Stuttgart (DE)
(72) Erfinder: Klar, Michael, 71106 Magstadt (DE); Binzer, Thomas, 70565 Stuttgart (DE); Miosga, Klaus-Dieter, 71522 Backnang (DE); Brueggemann, Oliver, 75248 Ölbronn-Dürrn (DE); Steinbuch, Dirk, 71299 Wimsheim (DE); Seiz, Juergen, 73642 Welzheim (DE)

(56) Entgegenhaltungen:
- US-A1- 2007 040 688
- US-A1- 2007 087 587
- US-B1- 6 801 438

## Beschreibung

Die Erfindung betrifft ein Verfahren zum Ausbilden einer Kontaktfläche auf einer Leiterplatte.

### Stand der Technik

In nahezu jedem elektrischen Gerät werden Leiterplatten verwendet, die mit vierschiedenen elektrischen Bauteilen bestückt sind. Leiterplatten werden meist in einem Mehrschichtverfahren hergestellt und weisen in der Regel einen Träger aus einem isolierenden Substrat mit einem geschichteten Schaltungslayout in Form von fest haftenden leitenden Verbindungen auf. Das geschichtete Schaltungslayout wird dabei durch Ätzen von dünnen Schichten aus leitfähigen Materialien hergestellt, die auf dem Substrat aufgebracht werden. Um die einzelnen Schichten des Schaltungslayouts zu verbinden, weist die Leiterplatte Durchkontaktierungen auf, die eine vertikale elektrische Verbindung zwischen den Leiterbahnenebenen herstellt.

Die Leiterplatte umfasst ferner Kontaktflächen auf dem Schaltungslayout zur elektrischen und mechanischen Anbindung der elektrischen Bauteile, mit denen die Leiterplatte bestückt wird. Die Kontaktflächen werden dabei in der Regel galvanisch auf dem Schaftungslayout aufgebracht. Ein Masseanschluss der Leiterplatte, der über eine elektrische Verbindung an dem Schaltungslayout angeschlossen ist, dient zum Stromfluss über die Leiterplatte bei der galvanischen Beschichtung, die in einem elektrolytischen Bad durchgeführt wird. Dabei wird herkömmlicher weise zuerst die gesamte Leiterplattenfläche vorzugsweise mit Gold beschichtet, um dann die Kontaktflächen zu strukturieren. Die elektrischen Bauteile werden aber ausschließlich auf die Kontaktflächen der Leiterplatte gelötet und so gleichzeitig mechanisch und elektrisch mit dem Schaltungslayout verbunden. Es werden aber auch andere Verfahren, wie Kleben, Klemmen und Schweißen eingesetzt.

Ferner wird die elektrische Verbindung zwischen dem Schaltungslayout und dem Masseanschluss nach dem galvanischen Beschichten und vor dem Aufbringen der elektrischen Bauteile durch Fräsen oder Bohren wieder durchtrennt, um den Kurzschluss im Schaltungslayout zu beseitigen. Bei der Unterbrechung der elektrischen Verbindung durch Bohren oder Fräsen besteht das Problem, dass Verschmutzungen insbesondere auf der Trennstelle auftreten können. Weiterhin kann die Trennstelle durch Bohren oder Fräsen angehoben werden, was dazu führt, dass Leiterbahnen im Schaftungslayout, die in der Umgebung der Trennstelle angeordnet sind und eine geringe Haftung zum Basismaterial haben, mit angehoben werden.

US 6,801,438 B1 zeigt ein Verfahren, in dem ein Laservorgang verwendet wird, um eine elektrischen Verbindung, die zur galvanischen Metallisierung einer Kontaktfläche einer Leiterplatte benötigt wurde, nach der Metallisierung zu entfernen.

### Offenbarung der Erfindung

Aufgabe der Erfindung ist es, ein verbessertes Verfahren bei der Metallbeschichtung einer Kontaktfläche zu ermöglichen.

Die Aufgabe der Erfindung wird durch ein Verfahren zum Ausbilden einer Kontaktfläche auf einer Leiterplatte nach Anspruch 1 gelöst. Weitere vorteilhafte Ausführungsformen der Erfindung sind in den abhängigen Ansprüchen angegeben.

Ein efindungsgemäßes Verfahren zum Ausbilden einer Kontaktfläche auf einer Leiterplatte umfasst Schritte des Bereitstellens der Leiterplatte mit einem Schaltungslayout und einer elektrischen Verbindung zwischen dem Schaltungslayout und einem Masseanschluss, des Erzeugens einer strukturierten Maskenschicht auf der Leiterplatte in Bereichen außerhalb der Kontaktfläche, des galvanischen Aufbringens einer leitenden Schicht im Bereich der Kontaktfläche auf der Leiterplatte durch Stromfluss durch den Masseanschluss, des Abdeckens der leitenden Schicht im Bereich der Kontaktfläche mit einer weiteren Maskenschicht, des Unterbrechens der elektrischen Verbindung zwischen dem Schaltungslayout und dem Masseanschluss durch einen Laservorgang und des Entfernens der Maskenschicht von der Leiterplatte.

Ein Vorteil des erfindungsgemäßen Verfahrens zum Ausbilden einer Kontaktfläche auf einer Leiterplatte ist, dass bei der Unterbrechung der elektrischen Verbindung zwischen dem Schaltungslayout und dem Masseanschluss durch den Laservorgang im Gegensatz zum Bohren oder Fräsen nur sehr wenige Rückstände entstehen. Ferner werden durch den Laservorgang die Leiterbahnen im Schaltungslayout, die in der Umgebung der Trennstelle angeordnet sind und eine geringe Haftung zum Basismaterial aufweisen, nicht angehoben. Des Weiteren können mit dem Entfernen der im Rahmen der Kontaktflächenherstellung eingesetzten Maskenschicht auch Rückstände bzw. Verunreinigungen, die durch den Laservorgang entstanden sind, beseitigt werden.

In einer Ausführungsform der Erfindung wird die Maskenschicht aus einem isolierenden Material ausgebildet. Da die strukturierte Maskenschicht die Leiterplatte weitgehend abdeckt, erfolgt die galvanische Beschichtung nur auf der Kontaktfläche. Dadurch kann leitendes Material bei der Beschichtung der Kontaktfläche auf der Leiterplatte eingespart werden.

In einer weiteren Ausführungsform der Erfindung wird die leitende Schicht auf der Kontaktfläche vor dem Laservorgang mit einer weiteren Maskenschicht abgedeckt. Durch das zusätzliche Abdecken der Kontaktfläche werden Kontaminationen der Bond- und Klebeflächen durch den Laservorgang verhindert.

Gemäß einer weiteren Ausführungsform der Erfindung ist die leitende Schicht aus Gold ausgebildet. Das Gold bildet eine metallische Schutz- und Kontaktschicht.

In einer weiteren Ausführungsform der Erfindung wird die elektrische Verbindung als eine Leiterbahn ausgebildet. Vorzugsweise wird die Leiterbahn der elektrischen Verbindung dünner ausgebildet als Leiterbahnen im Schaltungslayout und weist eine geringere Haftung zum Basismaterial auf. Durch diese Auslegung kann der Laservorgang vereinfacht werden.

Gemäß einer weiteren Ausführungsform der Verbindung wird eine auf der elektrischen Verbindung vorgegebene Lasertrennstelle auf der Maskenschicht vor dem Laservorgang markiert. Die vorgegebenen Lasertrennstellen weisen eine ausreichende Entfernung zur Kontaktfläche auf der Leiterplatte auf, sodass keine Verunreinigungen auf der Kontaktfläche der Leiterplatte durch den Laservorgang

entstehen. Dadurch kann die Herstellungszeit reduziert werden, da kein zusätzliches Abdecken der Kontaktfläche auf der Leiterplatte notwendig ist.

Die Erfindung wird im Folgenden anhand der beigefügten Zeichnung nähe erläutert. In der Zeichnung zeigt:

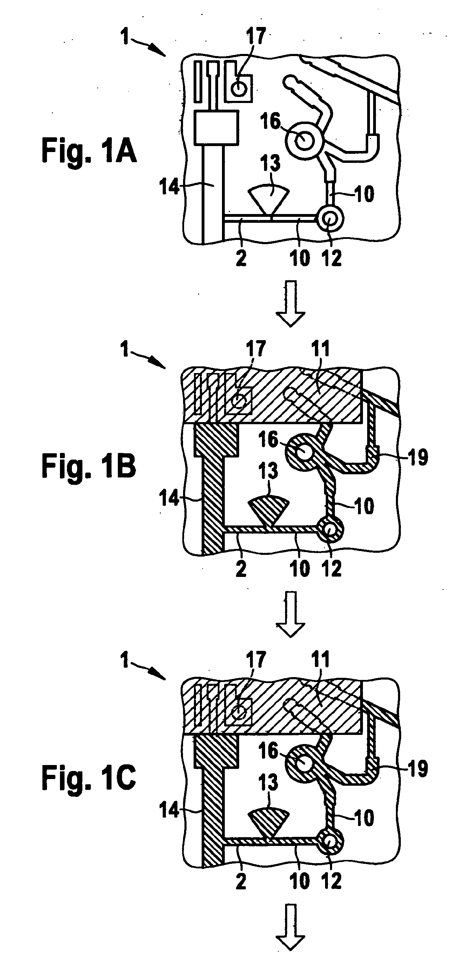

Fig. 1A -1E aufeinanderfolgende Verfahrensschritte zum Ausbilden einer Kontaktfläche auf einer Leiterplatte.

In der Figur 1A bis Figur 1E wird jeweils ein Ausschnitt einer Leiterplatte 1 gezeigt. Dabei kann die Leiterplatte 1, die mit einem Schaltungslayout 2 bereitgestellt wird, größer oder kleiner ausgebildet sein. Zudem können auf dem Schaltungslayout 2 verschiedene elektrische Bauteile integriert werden. Ferner können die Leiterbahnen des Schaltungslayout 2 dünner oder breiter sein sowie eine andere Anordnung aufweisen. Die Leiterplatte kann dabei in beliebigen elektrischen Gebieten eingesetzt werden.

Die Herstellung des Schaltungslayouts 2 auf der Leiterplatte 1 erfolgt meist in einem Mehrschichtverfahren. Hierzu werden auf einem Träger aus einem isolierenden Substrat dünne Schichten aus leitfähigen Materialien aufgebracht, aus denen die Leiterbahnen des Schaltungslayouts 2 geätzt werden. Um die einzelnen Schichten des Schaltungslayouts 2 zu verbinden, weist die Leiterplatte 1 eine Durchkontaktierung 16 auf, die eine vertikale elektrische Verbindung zwischen den Leiterbahnebenen herstellt. Die Durchkontaktierung 16 wird meist mit durch eine innen metallisierte Bohrung im Basismaterial der Leiterplatte realisiert. Gleichzeitig kann die Durchkontaktierung 16 als Bohrung oder Lötauge für elektrische Bauteile dienen oder nur zum Zweck der elektrischen Kontaktierung angebracht sein.

Die in den Figuren 1A bis 1E gezeigte Leiterplatte 1 kann in der Fahrzeugtechnik, insbesondere in einem ACC-System (Adaptiven Fahrgeschwindigkeitsregler), verwendet werden. Die Leiterplatte 1 kann aber auch in anderen Bereichen der Fahrzeugtechnik oder außerhalb der Fahrzeugtechnik verwendet werden. Die dargestellte Leiterplatte 1 wird vorzugsweise in einem Radarsensor des ACCSystems bei 76 GHz eingesetzt. Hierfür weist das Schaltungslayout 2 eine Hochfrequenzleitung 14 auf, die über eine Filterschaltung 13 kompensiert wird.

Für die Bestückung des Schaltungslayouts 2 der Leiterplatte 1 mit elektrischen Bauteilen ist eine Kontaktfläche 11 vorgesehen, die galvanisch beschichtet werden soll. Bei der galvanischen Beschichtung im Rahmen der Kontaktflächenherstellung ist ein Stromfluss notwendig. Dadurch ist, wie Figur 1A zeigt, das Schaltungslayout 2 der Leiterplatte 1 über eine elektrische Verbindung 10 an einen Massenanschluss 12 angeschlossen. Über den Masseanschluss 12 kann der gewünschte Stromfluss für die galvanische Beschichtung der Kontaktfläche 11 erzeugt werden. Des Weiteren ist ein zusätzlicher Masseanschluss 17 angeordnet, um mikroelektronische Bauteile anschließen zu können.

Zur Herstellung einer Kontaktfläche auf dem Schaltungslayout 2 wird, wie Figur 1B zeigt, in einem ersten Schritt eine strukturierte Maskenschicht 19 auf der Leiterplatte 1 erzeugt, um einen Bereich für die Kontaktfläche 11 auf der Leiterplatte 1 festzulegen. Dabei werden die Bereiche auf der Leiterplatte 1 mit einer Maskenschicht 19 abgedeckt, die später nicht galvanisch beschichtet werden sollen. Die vorstrukturierte Maskenschicht 19 ist vorzugsweise als Folie ausgebildet und wird auf die Leiterplatte 1 in der Regel aufgewalzt oder aufgepresst. Vorzugsweise ist die Maskenschicht 19 aus einem isolierenden Material ausgebildet, sodass der abgedeckte Bereich auf der Leiterplatte 1 bei der galvanischen Beschichtung nicht mit beschichtet und so Material eingespart wird. Die Maskenschicht 19 kann dabei aus einem Lack oder Kunststoff hergestellt werden.

Alternativ zu einer vorstrukturierten Lackschicht 19 kann jedoch erst auch auf die ganze Leiterplatte 1 eine Lackschicht 19 aufgebracht und anschließend strukturiert werden. Dabei werden mittels der Photolithographie Strukturinformationen von einer Fotomaske in einen Fotolack übertragen. Der Fotolack selbst wird zuvor durch eine Rotationsbeschichtung (Spin Coating) oder eine andere geeignete Methode auf die Leiterplatte 1 erzeugt. Die Schichtdicke von einem Mikrometer und darunter sind üblich, da der Fotolack nur als Deckschicht dient. Jedoch können Schichtdicken bis in den Millimeterbereich in einem oder mehreren Prozessschritten aufgebaut werden.

In einem weiteren Schritt wird, wie in Figur 1C gezeigt, eine leitende Schicht, die in dem Bereich der vorstrukturierten Maskenschicht 19, in denen die Kontaktfläche 11 ausgebildet werden soll, auf der Leiterplatte 1 galvanisch aufgebracht. Vorzugsweise wird die leitende Schicht aus Gold ausgebildet. Jedoch kann jedes andere elektrisch leitende Material, so z. B. Silber, verwendet werden, das sich galvanisch auf die Kontaktfläche 11 aufbringen lässt. Die galvanische Beschichtung der Kontaktfläche 11 erfolgt in einem elektrolytischen Bad, wobei Strom durch das elektrolyäsche Bad geschickt wird. Das elektrolytische Bad ist in der Regel als ein Kupfersulfatbad ausgebildet. Der Stromfluss erfolgt dabei über das Schaltungslayout 2 und dem Masseanschluss 12. Am Pluspol (Anode) befindet sich das Material für die leitende Schicht, die aufgebracht werden soll, am Minuspol (Kathode) die Leiterplatte 1. Der elektrische Strom löst dabei Metallionen vom Pluspol ab und lagert sie durch Reduktion auf den freiliegenden Bereich der strukturierten Maskenschicht 19. Die Maskenschicht 19 ist dabei isolierend ausgebildet, sodass kein Material auf der vorstrukturierten Maskenschicht 19 haften bleibt. Je länger sich die Leiterplatte 1 im elektrolytischen Bad befindet und je höher der elektrische Strom ist, desto dicker wird die leitende Schicht auf der Kontaktfläche 11 der Leiterplatte 1. Da nur der Bereich der Kontaktfläche 11 galvanisch beschichtet wird, kann Material bei der Beschichtung eingespart werden.

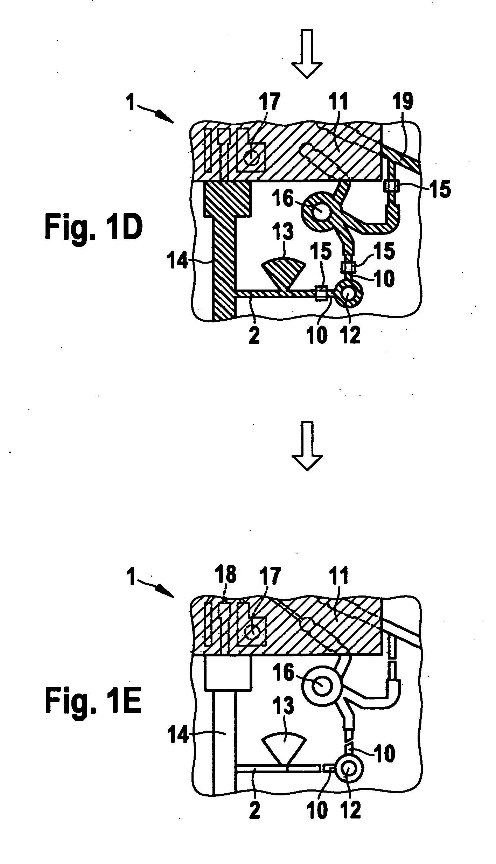

In einem nächsten Schritt wird, wie in Figur 1D gezeigt ist, die elektrische Verbindung 10 zwischen dem Schaltungslayout 2 und dem Masseanschluss 12 unterbrochen. Dies ist notwendig, um den Kurzschluss des Schaltungslayouts 2 wieder zu beseitigen. Die Maskenschicht 19 auf der Leiterplatte 1 ist vorzugsweise transparent ausgebildet, um die Lasertrennstelle 15 zwischen dem Schaltungslayout 2 und dem Masseanschluss 12 bei einem Laservorgang erkennen zu können. Bei einer nicht transparenten Maskenschicht 19 wird eine auf der elektrischen Verbindung 10 vorgegebenen Lasertrennstelle 15 auf der Maskenschicht 19 vor dem Laservorgang markiert. Die Lasertrennstelle 15 auf der Leiterplatte 1 ist zudem entfernt von der Kontaktfläche 11 angeordnet, sodass die Kontaktfläche 11 auf der Leiterplatte 1 bei dem Laservorgang nicht verschmutzt wird.

Alternativ kann nach dem galvanischen Beschichten der Kontaktfläche 11 der Leiterplatte 1, die leitende Schicht auf der Kontaktfläche 11 der Leiterplatte 1 vor dem Laservorgang mit einer weiteren Maskenschicht abgedeckt werden. Dies ist vor allem dann notwendig, wenn die Lasertrennstelle 15 zu nahe an der Kontaktfläche 11 auf der Leiterplatte 1 angeordnet ist. Somit kann eine Kontamination der Bond- und Klebefläche durch den Laservorgang vermieden werden. Bei dem Laservorgang wird der Laser genau positioniert und mit einer vorgegebenen Leistung eingestellt, um den Laservorgang präzise durchführen zu können.

Die Leiterbahn der elektrischen Verbindung 10 ist vorzugsweise dünner ausgelegt als die Leiterbahnen des Schaltungslayouts 2 und weist eine geringe Haftung zum Basismaterial auf. Dadurch kann die elektrische Verbindung 10 zwischen dem Schaltungslayout 2 und dem Masseanschluss 12 durch den Laservorgang einfach durchtrennt werden. Des Weiteren werden Leiterbahnen des Schaltungslayouts 2, die in der Umgebung der Lasertrennstelle 15 angeordnet sind und eine geringe Haftung zum Basismaterial aufweisen, durch den Laservorgang nicht angehoben, wie dies beim Fräsen oder Bohren der Fall sein kann. Durch den Laservorgang entstehen auch nur sehr wenige Rückstände bzw. Verunreinigungen an der Lasertrennstelle 15, sodass die Herstellungszeit der Leiterplatte 1 reduziert werden kann.

In einem abschließenden Schritt wird, wie in Figur 1E gezeigt, die Maskenschicht 19 von der Leiterplatte 1 wieder entfernt. Dabei wird die Maskenschicht 19 durch Belichten oder mit Chemikalien von der Leiterplatte 1 abgelöst. Alternativ kann die Maskenschicht 19 von der Leiterplatte 1 abgezogen werden. Mit dem Entfernen der Maskenschicht 19 werden auch Rückstände bzw. Verunreinigungen, die durch den Laservorgang auf der Lasertrennstelle 15 entstanden sind, mit entfernt. Da die Rückstände bzw. Verunreinigungen zusammen mit Maskenschicht 19 entfernt werden, kann ein schnelles Verfahren zum Ausbilden der Kontaktfläche 11 auf der Leiterplatte 1 sichergestellt werden.

Die Kontaktfläche 11 auf dem Schaltungslayout 2 dient zur elektrischen und mechanischen Anbindung von elektrischen Bauteilen, mit denen die Leiterplatte 1 bestückt wird. Dabei wird beispielsweise, wie in Figur 1E gezeigt, nach dem Entfernen der Maskenschicht 19 von der Leiterplatte 1 ein Bonddraht 18 auf der Kontaktfläche 11 der Leiterplatte 1 eingesetzt. Bei dem Bonddraht 18 handelt es sich um einen Anschlussdraht für mikroelektronische Bauteile, wie beispielsweise integrierte Schaltkreise oder LEDs. Zur Übertragung geringer Stromstärken wird insbesondere ein Bonddraht 18 mit kreisrundem Querschnitt aufgesetzt. Der Durchmesser eines derartigen Bonddrahts 18 mit kreisrundem Querschnitt ist meist im Bereich zwischen 25 und 50 µm. Für die Stromversorgung des Bonddrahts 18 ist ein zusätzlicher Masseanschluss 17 im Bereich der Kontaktfläche 11 auf der Leiterplatte 1 angeordnet. Jedoch können auch weitere elektrische Bauteile an der Kontaktfläche 11 integriert werden. Der Bonddraht ist hierbei nur als ein Beispiel für viele dargestellt.

## Patentansprüche

1. Verfahren zum Ausbilden einer Kontaktfläche (11) auf einer Leiterplatte (1) mit den Schritten:
• Bereitstellen der Leiterplatte (1) mit einem Schaltungslayout (2) und einer elektrischen Verbindung (10) zwischen dem Schaltungslayout (2) und einem Masseanschluss (12);,
• Erzeugen einer strukturierten Maskenschicht (19) auf der Leiterplatte (1) in Bereichen außerhalb der Kontaktfläche (11),
• galvanisches Aufbringen einer leitenden Schicht im Bereich der Kontaktfläche (11) auf der Leiterplatte (1), durch Stromfluss durch den Masseanschluss (12);
• Abdecken der leitenden Schicht im Bereich der Kontaktfläche (11) mit einer weiteren Maskenschicht;
• Unterbrechen der elektrischen Verbindung (10) zwischen dem Schaltungslayout (2) und dem Masseanschluss (12) durch einen Laservorgang, und
• Entfernen der Maskenschicht (19) von der Leiterplatte (1).

2. Verfahren nach Anspruch 1, wobei die Maskenschicht (19) aus einem isolierenden Material ausgebildet wird.

3. Verfahren nach einem der Ansprüche 1 oder 2, wobei die elektrische Verbindung (10) als eine Leiterbahn ausgebildet wird.

4. Verfahren nach Anspruch 3, wobei die Leiterbahn der elektrischen Verbindung (10) dünner ausgebildet wird als Leiterbahnen im Schaltungslayout (2).

5. Verfahren nach Anspruch 3 oder 4, wobei die Leiterbahn der elektrischen Verbindung (10) eine geringere Haftung zu einem Basismaterial der Leiterplatte (1) aufweist als Leiterbahnen im Schaltungslayout (2).

6. Verfahren nach einem der Ansprüche 1 bis 7, wobei eine auf der elektrischen Verbindung (10) vorgegebenen Lasertrennstelle (15) auf der Maskenschicht (19) vordem Laservorgang markiert wird.

## Claims

1. Method for forming a contact area (11) on a printed circuit board (1) comprising the following steps:
• providing the printed circuit board (1) having a circuit layout (2) and an electrical connection (10) between the circuit layout (2) and an earth connection (12),
• producing a patterned mask layer (19) on the printed circuit board (1) in regions outside the contact area (11),
• electrolytically applying a conductive layer in the region of the contact area (11) on the printed circuit board (1), by means of current flow through the earth connection (12);
• covering the conductive layer in the region of the contact area (11) with a further mask layer;
• interrupting the electrical connection (10) between the circuit layout (2) and the earth connection (12) by means of a laser process, and
• removing the mask layer (19) from the printed circuit board (1).

2. Method according to Claim 1, wherein the mask layer (19) is formed from an insulating material.

3. Method according to either of Claims 1 and 2, wherein the electrical connection (10) is embodied as a conductor track.

4. Method according to Claim 3, wherein the conductor track of the electrical connection (10) is made thinner than conductor tracks in the circuit layout (2).

5. Method according to Claim 3 or 4, wherein the conductor track of the electrical connection (10) has a lower adhesion to a base material of the printed circuit board (1) than conductor tracks in the circuit layout (2).

6. Method according to any of Claims 1 to 5, wherein a laser separating location (15) predefined on the electrical connection (10) is marked on the mask layer (19) before the laser process.

## Revendications

1. Procédé de formation d'une surface de contact (11) sur une carte de circuit (1), le procédé comportant les étapes qui consistent à :
- doter la carte de circuit (1) d'un motif de circuit (2) et d'une liaison électrique (10) entre le motif de circuit (2) et une borne (12) de raccordement à la masse,
- former une couche de masquage structurée (19) sur les parties de la carte de circuit (1) situées à l'extérieur de la surface de contact (11),
- appliquer par voie galvanique une couche conductrice sur la surface de contact (11) de la carte de circuit (1) en faisant passer du courant par la borne (12) de raccordement à la masse,
- recouvrir la couche conductrice de la surface de contact (11) par une autre couche de masquage,
- interrompre la liaison électrique (10) entre le motif de circuit (2) et la borne (12) de raccordement à la masse par une opération au laser et
- enlever la couche de masquage (19) de la carte de circuit (1).

2. Procédé selon la revendication 1, dans lequel la couche de masquage (19) est constituée d'un matériau isolant.

3. Procédé selon l'une des revendications 1 ou 2, dans lequel la liaison électrique (10) est configurée comme piste conductrice.

4. Procédé selon la revendication 3, dans lequel la piste conductrice de la liaison (10) est plus mince que les pistes conductrices du motif de circuit (2).

5. Procédé selon les revendications 3 ou 4, dans lequel la piste conductrice de la liaison électrique (10) présente une adhérence au matériau de base de la carte de circuit (1) plus faible que les pistes conductrices du motif de circuit (2).

6. Procédé selon l'une des revendications 1 à 5, dans lequel avant l'opération au laser, un emplacement prédéterminé (15) de découpe au laser est repéré sur la couche de masquage (19) au niveau de la liaison électrique (10).
